Europäisches Patentamt

European Patent Office

Office européen des brevets

(19)

(11) Publication number: **0 069 478**
**A2**

# EUROPEAN PATENT APPLICATION

(21) Application number: **82303038.2**

(22) Date of filing: **11.06.82**

(51) Int. Cl.³: **H 01 L 29/78**
**H 01 L 29/62, H 01 L 29/20**
**H 01 L 29/221**

(30) Priority: **01.07.81 GB 8120377**

(43) Date of publication of application:
**12.01.83 Bulletin 83/2**

(84) Designated Contracting States:
**DE FR NL**

(71) Applicant: **The Secretary of State for Defence in Her Britannic Majesty's Government of The United Kingdom of Great Britain and**
**Northern Ireland Whitehall**
**London SW1A 2HB(GB)**

(72) Inventor: **Dean, Anthony Brian**
**2 Purlieu Cottages Upper Colwall**
**Near Malvern Worcestershire(GB)**

(72) Inventor: **White, Anthony Michael**
**3 Guarlford Road**
**Malvern Worcestershire(GB)**

(74) Representative: **Edwards, John Brian et al,**
**Procurement Executive Ministry of Defence Patents 1 A**
**(4), Room 2014 Empress State Building Lillie Road**
**London SW6 1TR(GB)**

(54) **Metal-insulator-semiconductor devices.**

(57) A metal insulator semiconductor device comprises a semiconductor substrate (1, 15) having input and output terminals (2, 3, 79, 16, 17, 23, 24) with at least one gate (8, 20, 22) arranged on an insulating layer between the two terminals. In this invention the insulator under the gate is formed as a double layer (4, 5); the first layer (4, 18) next to the substrate, is thin e.g. less than 250Å whilst the second layer (5, 19) is thicker e.g. more than 350Å thick. One layer is accumulating whilst the other is depleting. The amount of band bending at the substrate insulator interface is controlled by the thickness of the first layer (4, 18). Substrate materials include $CD_xHg_{1-x}Te$, Si, InP, GaAs, GaAlAs. The first layer (4, 18) may be of anodic oxide. The second layer (5, 19) may be ZnS. Field effect transducers and charge coupled devices may be made incorporating the double layer gate insulator.

*Fig.1.*

METAL-INSULATOR-SEMICONDUCTOR DEVICES

This invention relates to metal-insulator-semiconductor (M.I.S.) devices.

Such devices have the layered structure of metal conductors, insulator e.g. of an oxide, semiconductor e.g. silicon. The conductor is usually but not necessarily metal. Sometimes the devices are termed M.O.S. devices i.e. metal-oxide-semiconductors, even though the insulator is not an oxide. Also because early devices were made on silicon, M.O.S. is sometimes taken to imply metal-oxide-silicon even though silicon is not the semiconductor.

A number of devices can be fabricated using M.I.S. structures; they include field effect transistors (F.E.T.) and charge coupled devices (C.C.D.). In both these known devices the passage of carriers along a semiconductor surface is controlled by an overlying gate electrode. This gate is insulated from the semiconductor with a material that affects the surface charge.

One semiconductor material useful in infra red (I.R.) detection systems is the alloy $Cd_xHg_{1-x}Te$ (C.M.T.). Various scanning systems have been built using arrays of detectors. Advantageously detectors can be combined with M.I.S. devices to process signals generated by incident I.R. Various monolithic devices, detectors plus M.I.S. devices, have been built as for example described in:- International Electron Devices Meeting, Dec. 1978, I.E.E.E.

pp. 496-500; App. Phys. Lett. 32(7) 1 April 1978, pp. 434/6; I.E.E.E. Trans. on Electron Devices, Vol. ED 27 No. 3, March 1980, pp. 591/595.

All known prior art devices using C.M.T. employ a thick (e.g. 700Å or more) passivating layer of oxide or zinc sulphide direct onto the C.M.T. Further insulating layers are also used. For example C.C.D. have been made with 700Å thick oxide on the C.M.T. substrate with gates on top and a further insulation of 2600Å thick ZnS.

In describing their action on the underlying semiconductor surface passivating layers may be accumulating or depleting or inverting. For n-type C.M.T. oxide passivation is accumulating i.e. attracts the majority carriers (electrons) to the C.M.T./passivator interface; ZnS is depleting i.e. depletes the C.M.T./passivator interface of electrons and in the extreme can produce inversion i.e. attracts minority carrier (holes) to the interface.

For p-type C.M.T. oxide passivation is depleting, i.e. depletes the C.M.T. of majority carriers (holes) at the interface and in the extreme can produce inversion i.e. attraction of minority carriers to the interface; ZnS passivation is accumulating i.e. accumulates holes at the interface.

The above effects can be explained with reference to conduction and valency bands. Oxide on C.M.T. bends the bands downwards at the surface whilst ZnS bends the bands upwards.

In all known prior art the thick initial passivation governs the nature i.e. depleting or accumulating of the semiconductor C.M.T./passivator interface. Additional layers of different insulators have no effect on the semiconductor C.M.T. band bending.

It has now been found that the amount of band bending (and hence the amount of accumulation/depletion/inversion) can be controlled by employing a very thin first passivating layer followed by a second thicker passivating layer, one layer being accumulating the other depleting. The band bending can be changed progressively and smoothly from one direction to the opposite direction as the thickness of the first layer increases near zero to around $250\overset{o}{A}$. This is a quantum mechanical effect, without which the band bending would always be of the magnitude and sign appropriate to the first insulator, and is therefore to be distinguished from existing double-layer structures where the first insulator is thick, and therefore alone determines the band bending.

According to this invention a M.I.S. device comprises a semiconductor substrate having input and output terminals with at least one gate arranged on an insulating layer between the input and output terminals the device being characterised by a double layer insulation under the gate, the double layer comprising a first very thin layer of one passivating material next to the substrate and a second thicker layer of another passivating material, one passivating material being of an accumulating type whilst the other is a depleting or inverting type.

The substrate may be $Cd_xHg_{1-x}Te$, Si, InP, GaAs, Ga, Al, As, etc.

The first layer may be anodic oxide of thickness less than $250\overset{o}{A}$. The second layer may be of zinc sulphide of thickness above $350\overset{o}{A}$ chosen to provide the necessary mechanical and electrical strength.

The substrate may be n or p-type.

The thin anodic oxide layer also restricts the drifts in device parameters due to defect and impurity motion frequently found in devices made with thicker anodic layers.

In one form of the invention the M.I.S. device is a field effect transistor and may operate as depletion-mode or enhancement-mode devices. Appropriate choice of first layer thickness allows selection of gate voltage, e.g. -2, -1, 0, 1, 2 etc. volts at device ON/OFF position.

In another form the M.I.S. device is formed as a C.C.D. having a plurality of gates forming clocking electrodes between input and output terminals.

The invention will now be described, by way of example only, with reference to the accompanying drawings, of which:-

Figure 1 is a sectional view of a field effect transistor;

Figure 2 is a sectional view of a charge coupled device;

Figure 3a, b are diagrams showing conduction and valency bands at the surface of a passivated substrate for accumulating and depleting insulating layers.

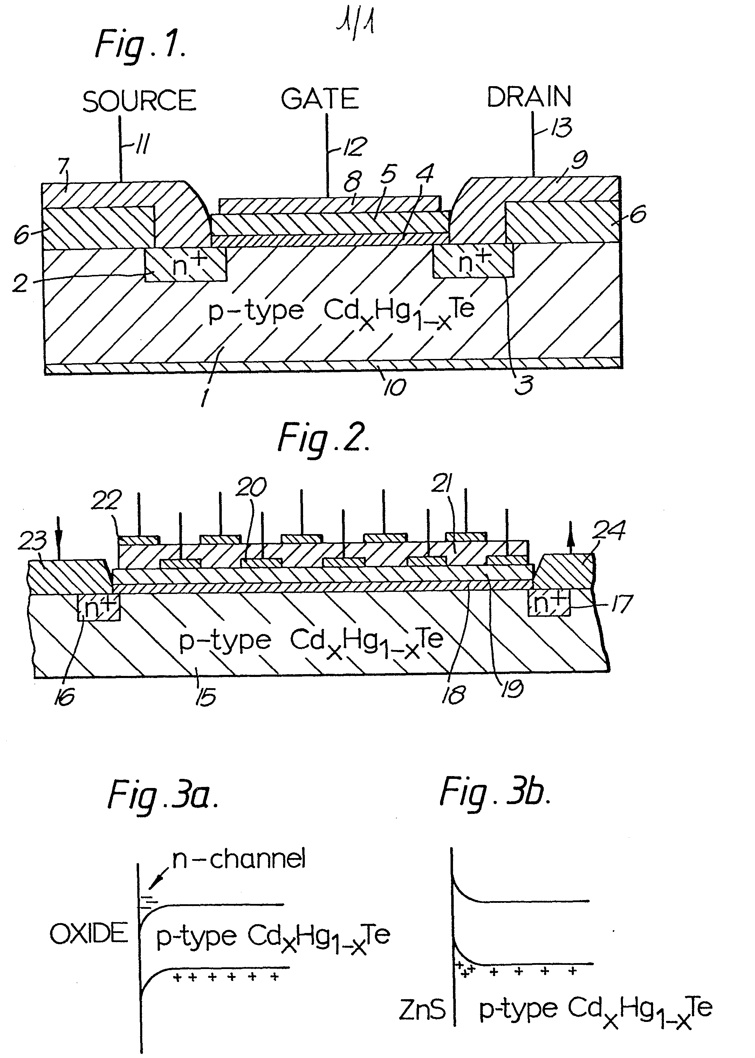

The field effect transistor(F.E.T.) of Figure 1 comprises a substrate 1 of $Cd_xHg_{1-x}Te$ (C.M.T.) doped p-type. The value of x is varied to suit the wavelength to be detected when part of the substrate is used as an infra red (I.R.) detector. For example x may be 0.3. Source and drain regions 2, 3 are formed in the substrate e.g. by Boron ion implantation to give $n^+$ regions.

A thin, less than 250Å, layer 4 of anodic oxide is grown on the substrate 1 between the source and drain 2, 3. One method of growing anodic oxide on C.M.T. is described in U.S. Patent No. 3,977,018.

A second insulating (passivating) layer 5 is grown on the oxide 4. This is typically a 700 to 1,200Å thick layer of zinc sulphide (ZnS) grown by evaporation or sputtering. The ZnS thickness is chosen to give the required mechanical and electrical properties, above about 200Å further increases in thickness do not affect accumulation or depletion in the substrate 1.

A thick e.g. 1,000Å or more layer 6 of ZnS is grown on the non-active surfaces of the substrate to give passivation and insulation.

Indium source, gate, and drain electrodes 7, 8, 9 respectively are evaporated into place and form pads for bonding electrical leads 11, 12, 13. A back gold electrode 10 may be evaporated onto the bottom of the substrate.

The effects of the double passivation is explained by reference to Figure 3 a, b. An oxide layer on p-type C.M.T. causes a depletion of holes near the surface Figure 3a. By itself a thick oxide layer gives a depletion mode F.E.T. i.e. electrons flow in an inversion layer ("n-channel") in the C.M.T. between source and drain with no applied gate voltage. To switch this flow OFF a negative gate voltage is necessary.

In a similar, but reverse, way a single thick layer of ZnS on p-type C.M.T. causes an accumulation of holes, Figure 3b, at the surface. This is an enhancement-mode device requiring a positive gate voltage to create an electron conducting channel in the C.M.T. surface.

For the device of Figure 1 a thin oxide layer 4 causes a depletion effect at the C.E.T. surface. However the ZnS layer 5 causes an accumulating effect. The net effect is accumulating or depleting as the value of the oxide layer 4 thickness varies from almost zero to about 250Å. This means that the amount of accumulation or depletion can be controlled by controlling the xoide thickness. Put another way, the gate voltage at which the device turns between ON and OFF is selected by selection of oxide thickness. This contrasts with prior art devices where the gate voltage at which ON/OFF effects occur can be multiplied by increasing insulator thickness but cannot have its sign changed or reduced to zero. An advantage of the thin oxide and thick ZnS is that the ON/OFF voltage value can be made zero or otherwise adjusted in growth schedule without the major changes associated with dispensing with one insulator, followed by changing the thickness of the remaining one. It releases the device from the built-in relationship between insulator thickness and turn ON voltage which exists for a given insulator.

In operation current flow between source and drain is controlled by suitable voltages applied to the gate electrode.

An alternative form of F.E.T. has an n-type substrate with p+ implanted source and drain region.

Figure 2 shows a C.C.D. comprising a p-type C.M.T. substrate 15 with ion implanted input and output regions 16, 17. Between these regions 16, 17 the substrate 15 has a double passivation covering of a thin layer 18 of native oxide (less than 250Å thick) and a thicker layer 19 of ZnS (700Å or more). Clocking electrode strips 20 of aluminium are formed on the ZnS layer. This is followed by a further ZnS layer 21 and clocking electrodes 22 arranged above the gaps between the first clocking electrodes 20. Electrical connections 23, 24 e.g. evaporated aluminium, are made to the input and output regions 16, 17. The various processing steps are conventional.

Operation of the device is conventional. A packet of charge is moved from the input regions 16 to the output regions 17 as a clocking voltage pulse is sequentially applied to the clocking electrodes 20, 22. Use of a double passivation layer 18, 19 gives control of the amount of accumulation or depletion and the level of clocking voltages necessary to move packets of charge. Layer thicknesses are as for the F.E.T. of Figure 1.

In a modification the substrate may be n-type with p+ input and output regions.

Claims:

1.      A metal insulator semiconductor device comprising a semiconductor substrate (1, 15) having input and output terminals (7, 8, 23, 24) with at least one gate arranged on an insulating layer between the input and output terminals the device being characterised by a double layer insulation under the gate, the double layer comprising a first very thin layer (4, 18) of one passivating material next to the substrate and a second thicker layer (5, 19) of another passivating material, one passivating material being of an accumulating type whilst the other is a depleting or inverting type.

2.      The device of claim 1 wherein the substrate is selected from the group comprising $Cd_xHg_{1-x}Te$, Si, InP, GaAs, GaAlAs.

3.      The device of claim 2 wherein the first layer (14, 18) is a layer less than 250Å in thickness of an oxide of the substrate material (1, 15).

4.      The device of claim 2 wherein the second layer (5, 19) is a layer of ZnS of thickness above 350Å.

5.      The device of claim 2 wherein the substrate (1, 15) is n-type.

6.      The device of claim 2 wherein the substrate (1, 15) is p-type.

7.      The device of claim 1 formed as a field effect transducer having source and drain electrodes (7, 9) with a double layer (4, 5) insulation between the gate electrode (8) and substrate (1).

8.      The device of claim 1 formed as a charge coupled device having source and drain electrodes (23, 24) and a plurality of clocking gate electrodes (20, 22) each insulated from the substrate by a double layer insulator (18, 19).

**Fig.1.**

1/1

SOURCE     GATE     DRAIN

p-type $Cd_xHg_{1-x}Te$

**Fig.2.**

p-type $Cd_xHg_{1-x}Te$

**Fig.3a.**

n–channel

OXIDE | p-type $Cd_xHg_{1-x}Te$

+ + + + + +

**Fig.3b.**

ZnS | p-type $Cd_xHg_{1-x}Te$